# EUROPEAN PATENT APPLICATION

(11) **EP 4 391 287 A1**
(43) Date of publication of application: **26.06.2024**
(21) Application number: 23205109.4
(22) Date of filing: 23.10.2023
(51) Int. Cl.: H02J 7/00, H01M 10/0562, H01M 10/0565, H01M 10/42, H01M 10/615, H01M 10/625, B60L 58/27

(54) **ALL-SOLID-STATE BATTERY SYSTEM, VEHICLE INCLUDING SAME, AND CONTROL METHOD FOR ALL-SOLID-STATE BATTERY**

(30) Priority: 06.12.2022 JP 2022194963
(71) Applicant: TOYOTA JIDOSHA KABUSHIKI KAISHA, Toyota-shi, Aichi-ken, 471-8571 (JP)
(72) Inventor: MIGITA, Tsubasa, TOYOTA-SHI, AICHI-KEN, 471-8571 (JP); NAGASE, Hiroshi, TOYOTA-SHI, AICHI-KEN, 471-8571 (JP); OGURA, Yoichi, TOYOTA-SHI, AICHI-KEN, 471-8571 (JP); MUKAI, Daisuke, TOYOTA-SHI, AICHI-KEN, 471-8571 (JP)
(74) Representative: Cabinet Beau de Loménie

(57) **Abstract**

A vehicle (1) equipped with an all-solid-state battery system includes a battery (21) that is an all-solid-state battery, an electric heater (22) that heats the battery (21) , and an ECU (100) that controls the electric heater (22). When charging of the battery (21) is resumed after a pause shorter than a predetermined time, the ECU (100) controls the electric heater (22) to raise a temperature of the battery (21) after resumption of the charging to a temperature higher than a temperature of the battery (21) before the pause of the charging.

## Description

### 1. Field of the Invention

The present disclosure relates to an all-solid-state battery system, a vehicle including same, and a control method for the all-solid-state battery.

### 2. Description of Related Art

In recent years, progress has been made in research and development of an all-solid-state battery suitable for vehicle installation. For example, a control device of an all-solid-state battery disclosed in Japanese Unexamined Patent Application Publication No. 2019-132696 is configured to estimate a state of charge (SOC) of the all-solid-state battery.

### SUMMARY OF THE INVENTION

In general, reaction unevenness along a thickness direction of a negative electrode is more likely to occur in all-solid-state batteries than in liquid-based batteries. When reaction unevenness arises in an all-solid-state battery, it leads to an increase in overvoltage, resulting in a rise in the battery's voltage.

The inventors of the present invention recognized that resuming the charging of an all-solid-state battery after a pause shorter than a predetermined time can result in particularly noticeable reaction unevenness. When the voltage of the all-solid-state battery rises due to the reaction unevenness, various inconveniences may occur after resuming charging. For example, lithium ions may be deposited on a surface of a negative electrode in the form of lithium metal. Alternatively, in some instances, the voltage of the all-solid-state battery can reach a predetermined full-charge determination voltage, leading to the termination of the charging, even when the battery has not actually reached full charge. It is desirable to prevent any inconvenience from arising due to reaction unevenness.

The present disclosure provides an all-solid-state battery system capable of preventing any inconvenience from arising due to reaction unevenness after resuming charging of the all-solid-state battery.

A first aspect of the invention relates to an all-solid-state battery system including an all-solid-state battery, a heating device, and a control device. The heating device heats the all-solid-state battery. The control device is configured to control the heating device. When charging of the all-solid-state battery is resumed after a pause shorter than a predetermined time, the control device is configured to control the heating device to raise a temperature of the all-solid-state battery after resumption of the charging to a temperature higher than a temperature of the all-solid-state battery before the pause of the charging.

In the first aspect, the all-solid-state battery may include an active material. The predetermined time may be a time required for reaction unevenness occurring in the active material to be resolved during the pause of the charging.

In the configuration, when resuming the charging of the all-solid-state battery after the pause shorter than the predetermined time, the heating device is controlled such that the temperature of the all-solid-state battery rises after the resumption of charging. As a result, the configuration promotes the mitigation of the reaction unevenness, and reduces the overvoltage resulting from the reaction unevenness. By reducing the overvoltage, the voltage rise of the all-solid-state battery can be mitigated. Therefore, with the above-described configuration, it is possible to prevent any inconvenience from arising due to reaction unevenness.

The first aspect may further include a voltage sensor that detects a voltage of the all-solid-state battery. When a detected value of the voltage sensor after the resumption of the charging exceeds a reference voltage, the control device may be configured to control the heating device to raise the temperature of the all-solid-state battery after the detected value of the voltage sensor exceeds the reference voltage to above a temperature of the all-solid-state battery before the detected value of the voltage sensor exceeds the reference voltage.

In the first aspect, the control device may be configured to set a target temperature of the all-solid-state battery and control the heating device such that a temperature of the all-solid-state battery reaches the target temperature, and when the detected value of the voltage sensor after the resumption of the charging exceeds the reference voltage, the control device may be configured to set the target temperature to a second target temperature that is higher than a first target temperature before the resumption of the charging.

In the first aspect, the all-solid-state battery system may further include a temperature sensor that detects a temperature of the all-solid-state battery. The control device may be configured to set the reference voltage to be lower as the detected temperature is lower

In the first aspect, the control device may be configured to set the reference voltage to be higher as the SOC of the all-solid-state battery is higher.

In the configuration, after the detected value of the voltage sensor exceeds the reference voltage, the heating device is controlled such that the temperature of the all-solid-state battery is lowered. As a result, it is possible to ensure the necessary heating time that promotes mitigation of reaction unevenness and reduces the overvoltage (in other words, to prevent unnecessary heating after the reaction unevenness is sufficiently mitigated and the overvoltage is reduced). Further, although the details will be described below, according to the above-described configuration, the heating time of the heating device can be adjusted to an appropriate length by appropriately setting the reference voltage.

In the first aspect, after the resumption of the charging, when an elapsed time from the pause of the charging exceeds a reference time, the control device may be configured to control the heating device to lower a temperature of the all-solid-state battery after the elapsed time exceeds the reference time to below a temperature of the all-solid-state battery before the elapsed time exceeds the reference time.

In the first aspect, the control device may be configured to set a target temperature of the all-solid-state battery and control the heating device such that the temperature of the all-solid-state battery reaches the target temperature. After the resumption of the charging, when the elapsed time from the pause of the charging does not exceed the reference time, the control device may be configured to set the target temperature to a second target temperature that is higher than a first target temperature before the resumption of the charging.

In the first aspect, the reference time may be shorter than the predetermined time.

In the first aspect, the reference time may be a remaining time obtained by subtracting a pause time of the charging from the predetermined time.

In the first aspect, the all-solid-state battery system may further include a temperature sensor that detects a temperature of the all-solid-state battery. The control device may be configured to set the reference time to be longer as the detected temperature is lower.

In the configuration, the heating device is controlled such that the temperature of the all-solid-state battery is lowered when the elapsed time after the pause of the charging exceeds the reference time. As a result, it is possible to ensure the necessary heating time that promotes mitigation of reaction unevenness and reduces the overvoltage. Moreover, according to the above-described configuration, the heating time of heating by the heating device can be adjusted to an appropriate length by appropriately setting the reference time.

A vehicle according to a second aspect of the present disclosure includes the all-solid-state battery system described above.

A control method of an all-solid-state battery according to a third aspect of the present disclosure includes charging the all-solid-state battery, and heating the all-solid-state battery such that when the charging is resumed after a pause shorter than a predetermined time, a temperature of the all-solid-state battery after resumption of the charging is higher than a temperature of the all-solid-state battery before the pause of the charging.

With the second aspect and the third aspect, as with the first aspect, it is possible to prevent any inconvenience from arising due to reaction unevenness.

With each aspect of the present disclosure, it is possible to prevent any inconvenience from arising due to reaction unevenness after resuming charging of the all-solid-state battery.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram illustrating an example of an overall configuration of a vehicle according to a first embodiment of the present disclosure;
FIG. 2 is a diagram for illustrating a voltage component of a battery related to temperature raising processing;
FIG. 3 is a time chart for illustrating an adjustment method of a target temperature in the temperature raising processing according to the first embodiment;
FIG. 4 is a flowchart illustrating a workflow sequence of the temperature raising processing according to the first embodiment;
FIG. 5 is a conceptual diagram illustrating an example of a map used for setting a reference voltage;
FIG. 6 is a time chart for illustrating an adjustment method of a target temperature in temperature raising processing according to a second embodiment; and
FIG. 7 is a flowchart illustrating a workflow sequence of the temperature raising processing according to the second embodiment.

### DETAILED DESCRIPTION OF EMBODIMENTS

Hereinafter, embodiments of the present disclosure will be described in detail with reference to the drawings. The same or corresponding parts in the drawings are denoted by the same reference numerals, and the description thereof will not be repeated.

A configuration in which an all-solid-state battery system according to the present disclosure is mounted on a vehicle will be described below as an example. However, the application of the all-solid-state battery system according to the present disclosure is not limited to vehicle use, and may have other uses such as stationary use.

### First Embodiment

### Vehicle Configuration

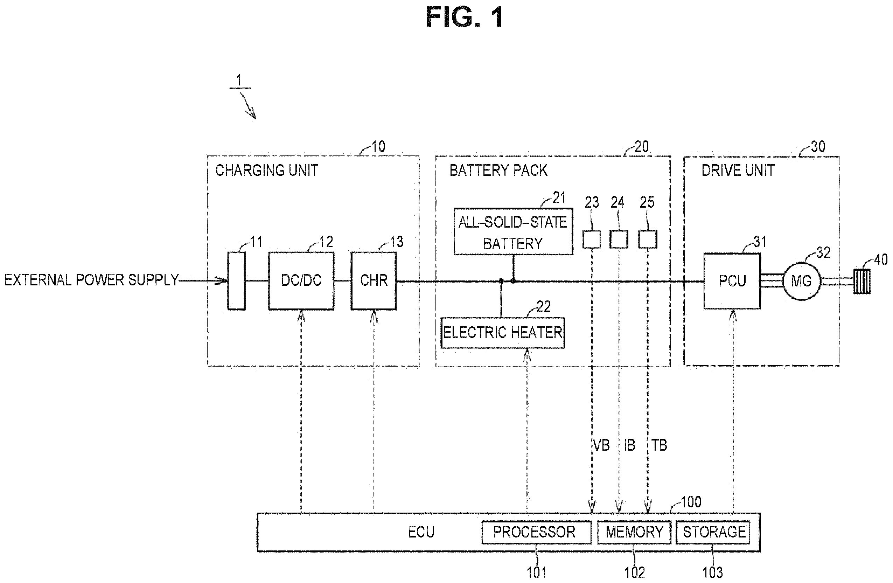

FIG. 1 is a diagram illustrating an example of an overall configuration of a vehicle according to a first embodiment of the present disclosure. A vehicle 1 is configured to be capable of external charging with electric power supplied from an external power supply (a charging station or the like) (not illustrated). External charging is plug-in charging in this example. However, the external charging may be non-contact charging. The vehicle 1 is an electric vehicle (battery electric vehicle: BEV) in this example. The vehicle 1 may be another type of vehicle such as a plug-in hybrid electric vehicle (PHEV).

The vehicle 1 includes a charging unit 10, a battery pack 20, a drive unit 30, a drive wheel 40, and an electronic control unit (ECU) 100. The charging unit 10 includes an inlet 11, a DC/DC converter 12, and a charging relay (charge relay: CHR) 13. The battery pack 20 includes a battery 21, an electric heater 22, a voltage sensor 23, a current sensor 24, and a temperature sensor 25. The drive unit 30 includes a power control unit (PCU) 31 and a motor generator 32.

The inlet 11 is configured such that a charging connector (not illustrated) of a charging cable is inserted thereinto with a mechanical connection such as a fit. The inlet 11 receives electric power supplied from an external power supply.

The DC/DC converter 12 is electrically connected between the inlet 11 and the charging relay 13. The DC/DC converter 12 lowers the voltage of DC power supplied from an external power supply through the inlet 11 in accordance with a control command from the ECU 100. An AC/DC converter (not illustrated) for normal charging may be provided instead of or in addition to the DC/DC converter 12 for rapid charging.

The charging relay 13 is electrically connected between the DC/DC converter 12 and the battery 21. The charging relay 13 is opened/closed according to a control command from the ECU 100. When the charging relay 13 is closed, electric power can be transferred between the inlet 11 and the battery 21.

The battery 21 is an assembled battery including a plurality of (typically several tens to several hundred) cells. Each cell is an all-solid-state battery. As the all-solid-state battery, batteries using various known materials such as those containing a sulfide-based solid electrolyte and those containing an oxide-based solid electrolyte can be employed. The battery 21 stores electric power for driving the motor generator 32 and supplies electric power to the motor generator 32 through the PCU 31. In addition, the battery 21 is charged by receiving regenerated electric power through the PCU 31 when the motor generator 32 regenerates electric power.

The electric heater 22 is, for example, a positive temperature coefficient (PTC) heater. In a low-temperature environment, the electric heater 22 heats the battery 21 using electric power supplied from an external power supply during plug-in charging. However, the electric heater 22 may operate with electric power supplied from the battery 21. The electric heater 22 is an example of a "heating device" according to the present disclosure.

The voltage sensor 23 detects the voltage (battery voltage VB) of the battery 21. The current sensor 24 detects a current IB that is input to and output from the battery 21. The temperature sensor 25 detects the temperature (battery temperature TB) of the battery 21. Each sensor outputs its detection result to the ECU 100.

The PCU 31 is configured to perform bidirectional electric power conversion between the battery 21 and the motor generator 32 in accordance with a control command from the ECU 100.

The motor generator 32 is an AC rotary electric machine, such as a three-phase AC synchronous motor with permanent magnets embedded in a rotor. The motor generator 32 mainly operates as an electric motor, and receives electric power from the battery 21 to rotationally drive the drive wheel 40. On the other hand, when the vehicle 1 decelerates (during braking, traveling downhill, or the like), the motor generator 32 operates as a power generator to perform regenerative power generation. Electric power generated by the motor generator 32 is charged to the battery 21 via the PCU 31.

The ECU 100 includes a processor 101, a memory 102, and a storage 103. The processor 101 is an arithmetic device such as a central processing unit (CPU) or a micro-processing unit (MPU). The memory 102 is a volatile memory (working memory) such as random access memory (RAM). The storage 103 is a rewritable non-volatile memory such as flash memory. The storage 103 stores system programs including an operating system (OS) and control programs including computer-readable codes necessary for control calculations. The processor 101 implements various processes by reading the system program and the control program, loading them into the memory 102, and executing them. The ECU 100 corresponds to the "control device" according to the present disclosure. The ECU 100 may be divided into a plurality of ECUs for each function.

Main processing executed by the ECU 100 in the present embodiment includes temperature raising processing of the battery 21. The temperature raising processing is, in this example, processing of operating the electric heater 22 such that the battery temperature TB (detected value of the temperature sensor 25) approaches a target temperature. The ECU 100 operates the electric heater 22 until the battery temperature TB reaches (or falls within a predetermined temperature range including the target temperature) the target temperature. The ECU 100 stops the electric heater 22 when the battery temperature TB reaches the target temperature. The ECU 100 operates the electric heater 22 again when the battery temperature TB falls below the target temperature (or the lower limit of the predetermined range).

### Reaction Unevenness

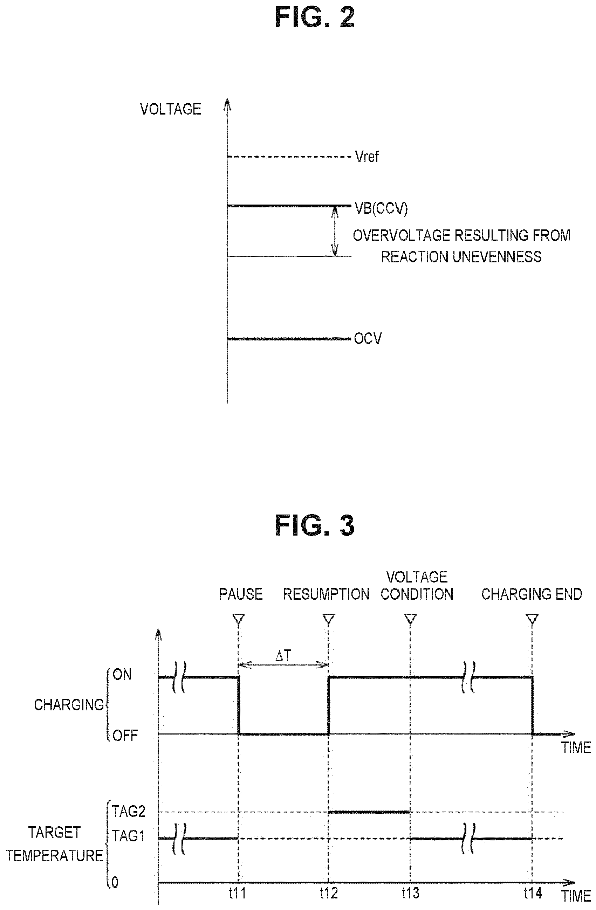

FIG. 2 is a diagram for illustrating voltage components of the battery 21 related to the temperature raising processing. The battery voltage VB detected by the voltage sensor 23 is the closed circuit voltage (CCV) of the battery 21 and higher than the open circuit voltage (OCV). A difference between the battery voltage VB and the OCV can include various components. One of these components is the overvoltage resulting from reaction unevenness that can occur within the all-solid-state battery.

In general, in a secondary battery, in terms of a thickness direction of the negative electrode, the closer it is to the positive electrode, the easier the charging reaction proceeds, and the farther it is away from the positive electrode, the slower the charging reaction proceeds. Therefore, reaction unevenness (uneven charging) may occur in the thickness direction of the negative electrode. In an all-solid-state battery that does not contain an electrolyte, reaction unevenness can be more prominent compared to a lithium-ion battery (liquid-based battery) that does contain an electrolyte. This is because in an all-solid-state battery that does not contain an electrolyte, the formation of an ion-conducting path between solid electrolytes in the thickness direction becomes challenging, resulting in a high resistance to the movement of lithium ions in that direction. Therefore, in the battery 21, which is an all-solid-state battery, the overvoltage resulting from the reaction unevenness tends to increase, and as a result, the battery voltage VB tends to rise.

The present inventors recognized that resuming the charging of an all-solid-state battery after a pause shorter than a predetermined time can result in particularly noticeable reaction unevenness. More specifically, during charging, lithium ions move from the positive electrode through the solid electrolyte layer to the negative electrode. In this case, it is known that lithium ions move (conduct) mainly by a hopping mechanism inside the solid electrolyte layer of the all-solid-state battery during charging (lithium ion hopping conduction). This means that when lithium ions enter the active material on a surface of the negative electrode, lithium ions undergo a pile-up movement. Since lithium ions are not newly supplied to the active material on the surface of the negative electrode during the charging pause period, such a pile-up movement of lithium ions does not occur. Therefore, there is a tendency for the reaction unevenness to persist, with lithium ions accumulating in the active material on the surface of the negative electrode before charging is paused. In a liquid-based battery, the electrolyte can mitigate the reaction unevenness, whereas in an all-solid-state battery, the electrolyte does not mitigate the reaction unevenness. Therefore, when the charging is resumed after the pause shorter than the predetermined time, the reaction unevenness may still occur.

When the battery voltage VB increases due to an overvoltage resulting from reaction unevenness, various inconveniences may occur after plug-in charging is resumed. For example, lithium ions may be deposited on the surface of the negative electrode in the form of lithium metal (lithium deposition). Alternatively, even when the battery 21 has not actually reached full charge, the battery voltage VB may reach a predetermined full charge determination voltage, leading to the termination of plug-in charging. It is desirable to prevent such an inconvenience from occurring.

Therefore, in the present embodiment, the ECU 100 raises the target temperature of the temperature raising processing of the battery 21 when plug-in charging is resumed after the pause shorter than a predetermined time. As a result, after the plug-in charging is resumed, the battery temperature TB is higher than before the plug-in charging is paused. In general, as the temperature of a lithium ion battery rises, the resistance associated with movement of lithium ions decreases. Therefore, when the battery temperature TB rises, the reaction unevenness is mitigated and the overvoltage is reduced. Then, the battery voltage VB, which increased during the pause in plug-in charging, decreases. As a result, it becomes possible to prevent any inconvenience from arising due to the reaction unevenness.

### Adjustment of Target Temperature

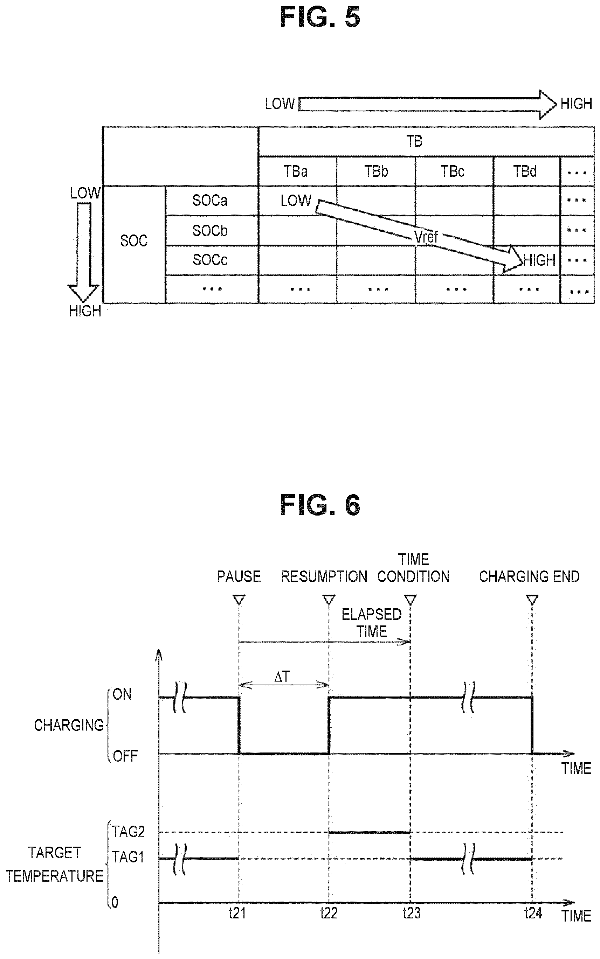

FIG. 3 is a time chart for illustrating an adjustment method of the target temperature in the temperature raising processing according to the first embodiment. The horizontal axis represents elapsed time. The vertical axis represents execution/non-execution of plug-in charging (electric power supply) and the target temperature of the battery 21. The same applies to FIG. 6, which will be described below.

In this example, at the initial time, the vehicle 1 is plug-in charging. Since the battery temperature TB is low in a low temperature environment (for example, below freezing point), it is desirable to raise the temperature of the battery 21 during plug-in charging. In this case, the target temperature of the battery 21 is set to TAG1. TAG1 is a temperature at which the increase in internal resistance due to low temperature is sufficiently small (negligible), typically room temperature (for example, 25°C).

Plug-in charging is paused at time t11, and plug-in charging is resumed at time t12. The reason for pausing and resuming plug-in charging is not particularly limited. As an example, a user pauses plug-in charging to board the vehicle 1 and leave, but the departure is postponed. Another example is when a temporary power outage occurs and then the electric power supply is restored. It is assumed that pause time ΔT of the plug-in charging is short enough to be considered a brief pause, such as several tens of seconds to several minutes.

The target temperature of the battery 21 after plug-in charging is resumed at time t12 is set to TAG2. TAG2 is a high temperature that is higher than TAG1 and can promote the mitigation of reaction unevenness. The higher the temperature of the battery 21, the more the reaction unevenness is mitigated. On the other hand, when the temperature of the battery 21 becomes excessively high, the charging power to the battery 21 reaches a control upper limit value Win, and charging to the battery 21 can be suppressed. Therefore, TAG2 is typically a temperature within a temperature range (for example, a temperature range of 35°C to 60°C) that is higher than room temperature and in which charging is not suppressed by the control upper limit value Win.

At time t13, a voltage condition is established indicating that the uneven reaction has been sufficiently mitigated (that is, resolved). More specifically, when the reaction unevenness is resolved, the overvoltage is reduced, so the battery voltage VB is lowered. Therefore, when the battery voltage VB becomes equal to or lower than a reference voltage Vref, it can be determined that the reaction unevenness has been resolved. When the battery voltage VB becomes equal to or lower than the reference voltage Vref, the target temperature of the battery 21 is again set to TAG1 in the present embodiment.

Thereafter, plug-in charging ends at time t14. Along with this, the temperature raising processing also ends.

In the example illustrated in FIG. 3, the target temperature when the reaction unevenness is resolved after plug-in charging is resumed is equal to the target temperature (= TAG1) before plug-in charging is paused. However, these two target temperatures may differ from each other. The former target temperature may be set to any temperature as long as it is lower than the target temperature (= TAG2) until the reaction unevenness is resolved after plug-in charging is resumed.

### Processing Flow

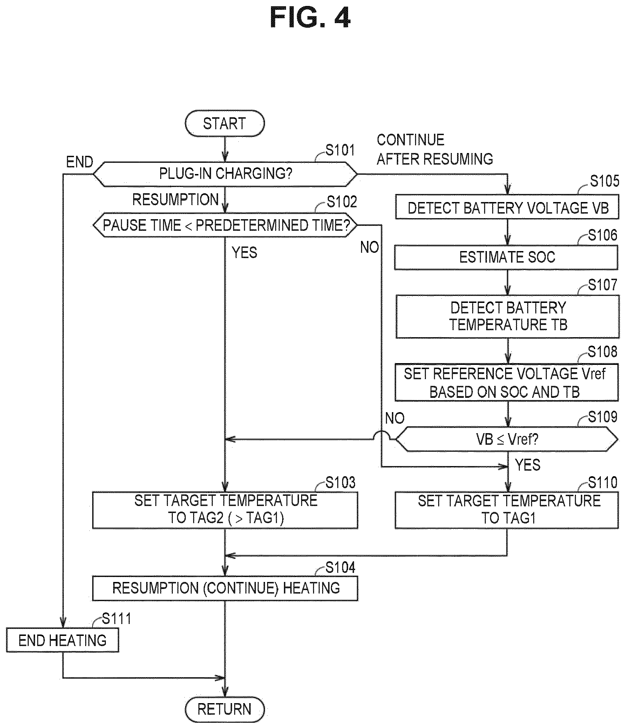

FIG. 4 is a flowchart illustrating a workflow sequence of the temperature raising processing according to the first embodiment. The processing illustrated in this flowchart is executed when a predetermined condition is satisfied (for example, every control cycle). As described above, it is assumed a situation occurs in which the battery temperature TB is low and the heating of the battery 21 starts.

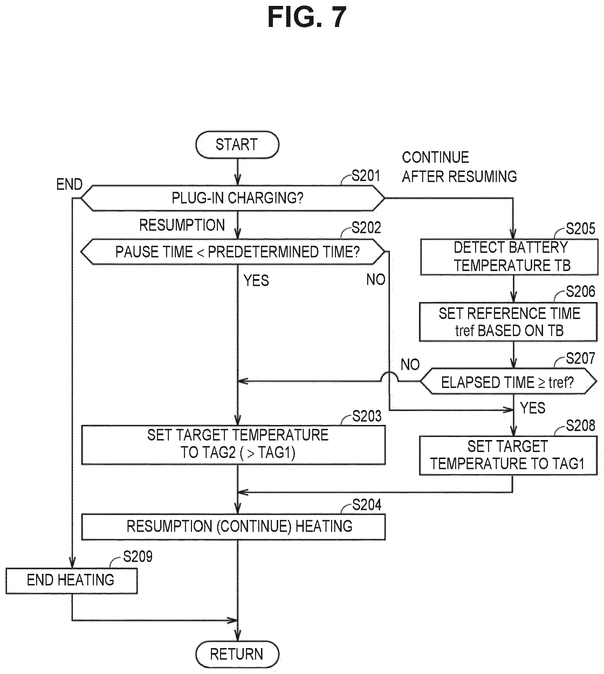

Each step is implemented through software processing by the ECU 100, although they could also be achieved through hardware (electric circuit) incorporated within the ECU 100. A step is abbreviated as S below. The same applies to FIG. 7, which will be described below.

In S101, the ECU 100 determines a status of the plug-in charging of the vehicle 1. In the example illustrated in FIG. 4, it is determined whether plug-in charging should be resumed, continued after resuming, or terminated.

When plug-in charging is resumed ("RESUME" in S101), the ECU 100 determines whether the pause time ΔT of the plug-in charging is less than a predetermined time (S102). The predetermined time is the time required for the reaction unevenness to be sufficiently mitigated (resolved) while the plug-in charging is paused, and is usually about several minutes to 10 minutes.

When the pause time ΔT of the plug-in charging is less than the predetermined time (YES in S 102), the ECU 100 sets the target temperature of the battery 21 to TAG2 (S103), and the ECU 100 controls the electric heater 22 to resume heating the battery 21 (S104).

Returning to S101, when plug-in charging is continued after resuming ("CONTINUE AFTER RESUMING" in S101), the ECU 100 executes processing (S105 to S108) to determine whether the reaction unevenness has been resolved by heating based on the battery voltage VB. The order of the processing of S105 to S108 can be changed as appropriate.

In S105, the ECU 100 acquires a detected value of the battery voltage VB from the voltage sensor 23.

In S106, the ECU 100 estimates the SOC of the battery 21. As an estimation method for SOC, a known method such as a method using a charge/discharge curve (OCV-SOC curve) or a current integration method can be used.

In S107, the ECU 100 acquires a detected value of the battery temperature TB from the temperature sensor 25. Although not illustrated, when the detected values of the temperatures of a plurality of cells are acquired from a plurality of temperature sensors, it is preferable to adopt the lowest temperature from among the temperatures of the cells as the detected value of the battery temperature TB. This is because it is considered that when the reaction unevenness in the cell with the lowest temperature is resolved, the reaction unevenness in all the cells will be resolved.

In S108, the ECU 100 sets the reference voltage Vref based on the SOC of battery 21 and the battery temperature TB. For example, the memory 102 of the ECU 100 stores a map that defines the correspondence between the SOC, the battery temperature TB, and the reference voltage Vref. The ECU 100 can set the reference voltage Vref from the SOC and the battery temperature TB by referring to the map. This map will be described below with reference to FIG. 5.

In S 109, the ECU 100 determines whether the battery voltage VB is equal to or less than the reference voltage Vref. When the battery voltage VB is higher than the reference voltage Vref (NO in S 109), in other words, when the battery voltage VB has not decreased to the reference voltage Vref, the reaction unevenness has not yet been resolved. Therefore, the ECU 100 maintains the target temperature of the battery 21 at TAG2 in order to continue heating at a high temperature (S103). On the other hand, when the battery voltage VB is equal to or lower than the reference voltage Vref, in other words, when the reaction unevenness is resolved and the battery voltage VB becomes lower than the reference voltage Vref, the ECU 100 resets the target temperature from TAG2 to TAG1 for the battery 21 (S 110). The ECU 100 then controls the electric heater 22 to continue heating the battery 21 (S104).

Returning to S101 again, when the plug-in charging ends ("END" in S101), the ECU 100 controls the electric heater 22 to end the heating of the battery 21 (S 111).

As described above, in the first embodiment, when a brief pause, shorter than a predetermined time (for example, several minutes to 10 minutes), occurs during plug-in charging of the battery 21, which is an all-solid-state battery, and the plug-in charging is subsequently resumed, the target temperature for the temperature raising processing of the battery 21 is increased. As a result, after resuming plug-in charging, the battery temperature TB rises compared to before the brief pause. As a result, mitigation of the reaction unevenness is promoted, and the overvoltage resulting from the reaction unevenness is reduced. Therefore, even when the battery voltage VB rises with the resumption of plug-in charging, the increase in the battery voltage VB can be mitigated by the reduction in the overvoltage that increased during the brief pause. Therefore, according to the first embodiment, it is possible to prevent any inconvenience from arising due to reaction unevenness.

FIG. 5 is a conceptual diagram illustrating an example of a map used for setting the reference voltage Vref. As illustrated in FIG. 5, the higher the SOC of the battery 21, the higher the reference voltage Vref is set. The higher the SOC of the battery 21, the higher the battery voltage VB, because the higher the OCV of the battery 21 is. Therefore, it is preferable to set the reference voltage Vref higher as the battery voltage VB increases. This is because when the reference voltage Vref remains low, the battery voltage VB may not drop to the reference voltage Vref, or it may take an excessively long time for the battery voltage VB to drop to the reference voltage Vref. To ensure that the battery voltage VB drops to the reference voltage Vref and to secure an appropriate length of heating time, the reference voltage Vref is set higher to be as SOC of the battery 21 increases.

In addition, the lower the battery temperature TB, the lower the reference voltage Vref is set. As the battery temperature TB decreases, the mitigation of the reaction unevenness becomes more challenging, and the reduction of the overvoltage becomes more difficult. Therefore, it is preferable that the reference voltage Vref is set to be lower as the battery temperature TB is lower, thereby lengthening the time until the battery voltage VB falls below the reference voltage Vref. This makes it possible to secure a longer heating time for resolving the reaction unevenness and reducing overvoltage.

FIG. 5 illustrates an example of a three-dimensional map in which the correspondence between the SOC, the battery temperature TB, and the reference voltage Vref is defined. However, instead of this, a two-dimensional map that defines the correspondence between the SOC and the reference voltage Vref may be used, or a two-dimensional map that defines the correspondence between the battery temperature TB and the reference voltage Vref may be used. Alternatively, the reference voltage Vref may be a fixed value.

Further, in S103 and S110, it is described that the target temperature of the temperature raising processing is controlled. However, the parameter to be controlled is not limited to the target temperature, and may be the heating amount [unit: W or Wh] which the battery 21recieved from the electric heater 22. The parameter to be controlled may be the extent of temperature rise [unit: °C] from a predetermined temperature, or the extent of temperature rise per unit time [unit: °C/sec]. The battery temperature TB can also be preferably controlled by controlling the heating amount, the extent of temperature rise, and/or the extent of temperature rise per unit time of the battery 21.

### Second Embodiment

In the first embodiment, it is described that whether the reaction unevenness is resolved is determined based on the reference voltage Vref. In a second embodiment, a configuration in which time is used instead of voltage will be described. The overall configuration of a vehicle according to the second embodiment is the same as the configuration illustrated in FIG. 1

FIG. 6 is a time chart for illustrating an adjustment method of a target temperature in a temperature raising processing according to the second embodiment. This time chart differs from the time chart (see FIG. 3) of the first embodiment in that the time condition is used instead of the voltage condition at time t23. The time condition is whether the elapsed time from the pause time (time t21) of plug-in charging exceeds a reference time tref. Since other matters are the same as those of the first embodiment (see FIG. 3), detailed description will not be repeated.

FIG. 7 is a flowchart illustrating a workflow sequence of the temperature raising processing according to the second embodiment. The processing of S201 to S204 is equivalent to the processing of S101 to S104 (see FIG. 4) in the first embodiment.

When plug-in charging is continued after resuming ("CONTINUE AFTER RESUMING" IN S201), the ECU 100 executes processing (S205 to S207) to determine based on time whether the reaction unevenness has been resolved by heating.

In S205, the ECU 100 acquires a detected value of the battery temperature TB from the temperature sensor 25.

In S206, the ECU 100 sets a reference time tref based on the battery temperature TB. For example, the memory 102 of the ECU 100 stores a map that defines the correspondence between the battery temperature TB and the reference time tref. The ECU 100 can set the reference time tref from the battery temperature TB by referring to the map.

It is preferable that the reference time tref is set to be longer as the battery temperature TB is lower. As described in the first embodiment, the lower the battery temperature TB, the more difficult it is for the reaction unevenness to be mitigated, so the reference time tref is set longer to secure a longer heating time for mitigating reaction unevenness and reducing overvoltage.

However, the setting method of the reference time tref is not limited to this. The reference time tref may be shorter than the time (predetermined time described above) required for the response unevenness to be resolved during pause of plug-in charging. The reference time tref may be determined by subtracting the pause time ΔT of the plug-in charging from the predetermined time, resulting in a remaining time. For example, when the predetermined time is 10 minutes and the pause time ΔT is three minutes, the reference time tref can be set to seven minutes. The reference time tref may be a fixed value.

In S207, the ECU 100 determines whether the elapsed time from the pause time of the plug-in charging is equal to or greater than the reference time tref. When the elapsed time is shorter than the reference time tref (NO in S207), it is considered that the reaction unevenness has not yet been resolved. Therefore, the ECU 100 maintains the target temperature of the battery 21 at TAG2 in order to continue heating at a high temperature (S203). The ECU 100 then controls the electric heater 22 to continue heating the battery 21 (S204). On the other hand, when the elapsed time is equal to or longer than the reference time tref (YES in S207), there is a high possibility that the reaction unevenness has been resolved, so the ECU 100 resets the target temperature from TAG2 to TAG1 for the battery 21 (S208). The ECU 100 then controls the electric heater 22 to continue heating the battery 21 (S204). The subsequent processing of S209 is similar to the processing of Sill in the first embodiment.

As described above, in the second embodiment as well as in the first embodiment, when a brief pause shorter than a predetermined time occurs during the plug-in charging of the battery 21, and the plug-in charging is subsequently resumed, the target temperature for the temperature raising processing of the battery 21 is increased. As a result, it is possible to prevent any inconvenience from arising due to reaction unevenness.

In addition, in the first and second embodiments, the configuration which adopts the electric heater 22 as the "heating device" according to the present disclosure is described. However, the "heating device" according to the present disclosure is not limited to this as long as it is configured to heat the battery 21, which is an all-solid-state battery.

Although not illustrated, for example, a vehicle configuration having a liquid-cooled temperature control system in which a common coolant flows between a power train system (PCU 31 and motor generator 32) and the battery 21 is conceivable. In such a vehicle configuration, the "heating device" according to the present disclosure may be the powertrain system. The battery 21 can be heated by using heat generated by the powertrain system to warm the coolant, which is then circulated through the battery 21. In this case, the motor generator 32 may be intentionally driven with large heat loss. More specifically, strong field/weak field control of the motor generator 32 may be implemented such that an operating point of the motor generator 32, represented on a current advancing angle-torque plane, is off the optimum operating line where heat loss is minimized.

Alternatively, a configuration in which heat is exchanged via a heat exchanger between a heat pump type air conditioner and a cooling device of the liquid cooling type battery 21 is also conceivable. In such vehicle configurations, the "heating device" according to the present disclosure may be an air conditioner. As in the powertrain system example above, the battery 21 can be heated by using the heat generated by the air conditioner to warm the coolant and circulating the warmed coolant through the battery 21.

The embodiments disclosed this time should be considered as examples and not restrictive in all respects. The scope of the present disclosure is indicated by the scope of the claims rather than the description of the above-described embodiments, and is intended to include all modifications within the scope and meaning equivalent to the scope of the claims.

## Claims

1. An all-solid-state battery system, comprising:
an all-solid-state battery (21);
a heating device (22) for heating the all-solid-state battery (21); and
a control device (100) configured to control the heating device (22) so that,
when charging of the all-solid-state battery (21) is resumed after a pause shorter than a predetermined time, the control device (100) controls the heating device (22) to raise a temperature of the all-solid-state battery (21) after resumption of the charging to a temperature higher than a temperature of the all-solid-state battery (21) before the pause of the charging.

2. The all-solid-state battery system according to claim 1, wherein:
the all-solid-state battery (21) includes an active material; and
the predetermined time is a time required for reaction unevenness occurring in the active material to be resolved during the pause of the charging.

3. The all-solid-state battery system according to claim 1 or 2, further comprising
a voltage sensor (23) for detecting a voltage of the all-solid-state battery (21), wherein the control device (100) is configured so that,
when a detected value of the voltage sensor (23) after the resumption of the charging exceeds a reference voltage, the control device (100) controls the heating device (22) to raise a temperature of the all-solid-state battery (21) after the detected value of the voltage sensor (23) exceeds the reference voltage to above a temperature of the all-solid-state battery (21) before the detected value of the voltage sensor (23) exceeds the reference voltage.

4. The all-solid-state battery system according to claim 3, wherein:
the control device (100) is configured to set a target temperature of the all-solid-state battery (21), control the heating device (22) such that the temperature of the all-solid-state battery (21) reaches the target temperature and, when the detected value of the voltage sensor (23) after the resumption of the charging exceeds the reference voltage, set the target temperature to a second target temperature that is higher than a first target temperature before the resumption of the charging.

5. The all-solid-state battery system according to claim 3 or 4, further comprising
a temperature sensor (25) that detects a temperature of the all-solid-state battery (21), wherein
the control device (100) is configured to set the reference voltage to be lower as the detected temperature is lower.

6. The all-solid-state battery system according to any one of claims 3 to 5, wherein the control device (100) is configured to set the reference voltage to be higher as state of charge (SOC) of the all-solid-state battery (21) is higher.

7. The all-solid-state battery system according to claim 1 or 2, wherein the control device (100) is configured so that, after the resumption of the charging, when an elapsed time from the pause of the charging exceeds a reference time after the resumption of the charging, the control device (100) controls the heating device (22) to lower a temperature of the all-solid-state battery (21) after the elapsed time exceeds the reference time to below a temperature of the all-solid-state battery (21) before the elapsed time exceeds the reference time.

8. The all-solid-state battery system according to claim 7, wherein:
the control device (100) is configured to set a target temperature of the all-solid-state battery (21), control the heating device (22) such that the temperature of the all-solid-state battery (21) reaches the target temperature and, after the resumption of the charging, when the elapsed time from the pause of the charging does not exceed the reference time, set the target temperature to a second target temperature that is higher than a first target temperature before the resumption of the charging.

9. The all-solid-state battery system according to claim 7 or 8, wherein the reference time is shorter than the predetermined time.

10. The all-solid-state battery system according to claim 9, wherein the reference time is a remaining time obtained by subtracting a pause time of the charging from the predetermined time.

11. The all-solid-state battery system according to any one of claims 7 to 10, further comprising
a temperature sensor (25) for detecting a temperature of the all-solid-state battery (21), wherein
the control device (100) is configured to set the reference time to be longer as the detected temperature sensor is lower.

12. A vehicle (1), comprising the all-solid-state battery system according to any one of claims 1 to 11.

13. A control method for an all-solid-state battery (21), comprising:
charging the all-solid-state battery (21); and
heating the all-solid-state battery (21) such that when the charging is resumed after a pause shorter than a predetermined time, a temperature of the all-solid-state battery (21) after resumption of the charging is higher than a temperature of the all-solid-state battery (21) before the pause of the charging.
